# EUROPÄISCHE PATENTSCHRIFT

(11) **EP 4 078 203 B1**
(45) Veröffentlichungstag und Bekanntmachung des Hinweises auf die Patenterteilung: **12.02.2025**
(21) Anmeldenummer: 20824154.7
(22) Anmeldetag: 08.12.2020
(51) Int. Cl.: G01R 31/28

(54) **MESSSYSTEM ZUR ERFASSUNG EINES PHYSIKALISCHEN PARAMETERS UND VERFAHREN ZUM BETREIBEN EINES MESSSYSTEMS**
MEASUREMENT SYSTEM FOR DETECTING A PHYSICAL PARAMETER, AND METHOD FOR OPERATING A MEASUREMENT SYSTEM
SYSTÈME DE MESURE POUR ACQUÉRIR UN PARAMÈTRE PHYSIQUE ET PROCÉDÉ POUR FAIRE FONCTIONNER UN SYSTÈME DE MESURE

(30) Priorität: 16.12.2019 DE 102019134505
(43) Veröffentlichungstag der Anmeldung: 26.10.2022
(73) Patentinhaber: KNORR-BREMSE Systeme für Nutzfahrzeuge GmbH, 80809 München (DE)
(72) Erfinder: BELLING, Michael, 71272 Renningen (DE); KAUFMANN, Christian, 71063 Sindelfingen (DE)
(86) Internationale Anmeldenummer: PCT/EP2020/085045
(87) Internationale Veröffentlichungsnummer: WO 2021/122146

(56) Entgegenhaltungen:
- EP-A1- 3 382 895
- DE-A1- 102009 044 178
- JP-A- 2008 302 825
- US-A1- 2018 304 916

## Beschreibung

Die Erfindung geht von einem Messsystem oder einem Verfahren nach Gattung der unabhängigen Ansprüche aus. Gegenstand der vorliegenden Erfindung ist auch ein Computerprogramm.

In modernen Sensorsystemen, speziell die in Fahrzeugen verbaut sind, sollte sichergestellt sein, dass diese Sensorsysteme möglichst gut gegen einen Ausfall von Systemkomponenten geschützt sind. Hierzu ist es oftmals üblich, redundante Systeme oder Energieversorgungseinheiten vorzusehen, durch welche ein Messsensor mit Energie versorgt wird, sodass bei einem Ausfall eines solchen Energieversorgungssystems ein redundantes Energieversorgungssystem zur Speisung des Messsensors mit Energie einspringt. Problematisch ist jedoch, wenn die Energieversorgungssystem auf unterschiedlichen Massepotenzialen basieren, sodass der Messsensor nicht mit einer einheitlichen Spannung versorgt wird und hierdurch gegebenenfalls bei einem Wechsel des versorgenden Energieversorgungssystems fehlerhafte Messwerte liefert.

Die DE 10 2009 044 178 A1 offenbart einen Leistungsversorgungsschaltkreis, der eine Last mit elektrischer Leistung von einer Leistungsquelle versorgt, und ein Signaldetektionsgerät, das den Leistungsversorgungsschaltkreis verwendet. Dabei können mehrfach Leistungsleitungssysteme vorgesehen sein, die ausgestaltet sind, um einen Erdschluss in einem Leistungsleitungssystem, das die anderen Leistungsleitungssysteme beeinflusst, zu verhindern. Die US 2018/0304916 A1 offenbart eine Sensorvorrichtung für eine elektrische Servolenkung.

### Offenbarung der Erfindung

Vor diesem Hintergrund werden mit dem hier vorgestellten Ansatz ein Messsystem, weiterhin ein Verfahren zum Betreiben dieses Messsystems, sowie schließlich ein → Seite 1a

entsprechendes Computerprogramm gemäß den Hauptansprüchen vorgestellt. Durch die in den abhängigen Ansprüchen aufgeführten Maßnahmen sind vorteilhafte Weiterbildungen und Verbesserungen des im unabhängigen Anspruch angegebenen Messsystems möglich.

Es wird daher ein im beigefügten Anspruch 1 beschriebenes Messsystem zur Erfassung eines physikalischen Parameters vorgestellt.

Unter einem physikalischen Parameter kann beispielsweise eine physikalische Größe wie eine Drehzahl, eine Beschleunigung, eine Temperatur oder dergleichen verstanden werden. Unter einer Energieversorgungseinheit kann beispielsweise eine Einheit verstanden werden, die elektrische Energie in Form eines Stroms und/oder einer Spannung an den Messsensor bereitstellt. Hierbei sind die erste Energieversorgungseinheit und die zweite Energieversorgungseinheit auf unterschiedlichen Massepotenzialen gestützt, beispielsweise aufgrund einer galvanischen Trennung oder aufgrund von zwischen diesen Massepotenzialen liegenden langen elektrische Verbindungsleitungen, die als elektrischer Widerstand dienen und die dazu führen, dass sich die Massepotenziale voneinander unterscheiden. Unter von der zweiten Energieversorgungseinheit an den Messsensor ausgegebenen oder an dem Messsensor anliegenden Spannung kann eine Spannung verstanden werden, die erste Spannung zuzüglich oder abzüglich einer Differenz zwischen dem ersten und zweiten Massepotenzial entspricht.

Der hier vorgeschlagene Ansatz basiert auf der Erkenntnis, dass durch die Ausgabe der unter Berücksichtigung der ersten Spannung bzw. des ersten Massepotenzials ermittelten zweiten Spannung durch die zweite Energieversorgungseinheit eine Versorgung des Messsensors durch die erste und zweite Energieversorgungseinheit ermöglicht wird, wobei der Messsensor selbst eine nahezu gleiche Spannung sowohl von der ersten Energieversorgungseinheit als auch von der zweiten Energieversorgungseinheit erhält und somit weit gehend fehlerfrei arbeiten kann. Dies ist auch dann möglich, wenn das erste Massepotenzial und das zweite Massepotenzial voneinander unterschiedlich sind. Im Endeffekt wird somit durch die zweite Energieversorgungseinheit sichergestellt, dass bei der Ausgabe der zweiten Spannung eine Potenzialdifferenz zwischen dem ersten Massepotenzial und den zweiten Massepotenzial berücksichtigt bzw. ausgeglichen wird, um die Funktionsweise des Messsensors bzw. Robustheit der Funktion des Messsensors zu optimieren. Zugleich lässt sich hierdurch der Messsensor sowohl mit der ersten Energieversorgungseinheit als auch zeitgleich mit der zweiten Energieversorgungseinheit koppeln, da durch die am Messsensor anliegende im Wesentlichen gleiche Spannung sowohl von Seiten der ersten Energieversorgungseinheit als auch von Seiten der zweiten Energieversorgungseinheit kein Fehlerstrom von der ersten Energieversorgungseinheit in die zweite Energieversorgungseinheit und umgekehrt fließt.

Günstig ist eine Ausführungsform des hier vorgeschlagenen Ansatzes, bei der die erste Energieversorgungseinheit zumindest einen durch eine erste Steuereinheit steuerbaren ersten Schalter aufweist, um einen Stromfluss von dem Messsensor durch die erste Energieversorgungseinheit zu dem ersten Massepotenzial zu unterbrechen. Zusätzlich oder alternativ kann die zweite Energieversorgungseinheit zumindest einen durch eine zweite Steuereinheit steuerbaren zweiten Schalter aufweisen, um einen Stromfluss von dem Messsensor durch die zweite Energieversorgungseinheit zu dem zweiten Massepotenzial zu unterbrechen. Eine solche Ausführungsform des hier vorgeschlagenen Ansatzes bietet den Vorteil, aktiv einen, an den Betriebs-/Fehlerfall angepassten, Strompfad definieren zu können, sodass beispielsweise bei der Erkennung eines Fehlers oder einer Fehlfunktion in einer der Energieversorgungseinheit die Energieversorgung des Messsensors dennoch zuverlässig sichergestellt werden kann.

Gemäß einer Ausführungsform des hier vorgeschlagenen Ansatzes kann die erste Steuereinheit ausgebildet sein, um den ersten Schalter zu öffnen, wenn eine Fehlfunktion der ersten Energieversorgungseinheit erkannt wurde. Alternativ oder zusätzlich kann die zweite Steuereinheit ausgebildet sein, um den zweiten Schalter zu öffnen, wenn eine Fehlfunktion der zweiten Energieversorgungseinheit erkannt wurde. Unter einer Fehlfunktion kann beispielsweise das Auftrefen eines Hardware- oder Softwarefehlers, ein Leitungsbruch oder dergleichen verstanden werden, die die Funktionsfähigkeit der betreffenden Energieversorgungseinheit zumindest teilweise beeinträchtigt oder vollständig ausfallen lässt. Eine solche Ausführungsform bietet den Vorteil, bei einem Erkennen einer Fehlfunktion in einer der Energieversorgungseinheiten die Energieversorgung des Messsensors durch diese Energieversorgungseinheit zu unterdrücken, sodass eine möglichst stabile und sichere Funktionsweise des Messsensor gewährleistet werden kann.

Denkbar ist auch eine Ausführungsform des hier vorgeschlagenen Ansatzes, bei der die erste Steuereinheit ausgebildet ist, um den ersten Schalter zu schließen oder geschlossen zu halten, wenn eine Fehlfunktion in der zweiten Energieversorgungseinheit erkannt wurde. Alternativ oder zusätzlich kann die zweite Steuereinheit ausgebildet sein, um den zweiten Schalter zu schließen oder geschlossen zu halten, wenn in der ersten Energieversorgungseinheit eine Fehlfunktion erkannt wurde. Eine solche Ausführungsform bietet den Vorteil sicherzustellen, dass bei einem erkannten Fehlerfall in einer anderen Energieversorgungseinheit der Messsensor zuverlässig durch die betrachtete Energieversorgungseinheit gespeist werden kann. In diesem Fall wird dann der Messsensor von der betrachtete Energieversorgungseinheit mit einem Strom gespeist wobei zugleich auch der vom Messsensor abfließende Strom durch die Energieversorgungseinheit fließt und gegebenenfalls auf das Vorliegen eines Codes ausgewertet wird, in dem der physikalische Parameter durch den Messsensor codiert ist.

Besonders vorteilhaft ist eine Ausführungsform des hier vorgeschlagenen Ansatzes, bei der der Messsensor derart mit der ersten und zweiten Energieversorgungseinheit in einer Versorgungsschaltung verschaltet ist, dass ihm ein Strom von der zweiten Energieversorgungseinheit zugeführt wird und ein Strom von ihm zu der ersten Energieversorgungseinheit abgeführt wird, insbesondere wobei der Messsensor in einem Normalbetrieb in der Versorgungsschaltung geschaltet ist. Eine solche Ausführungsform des hier vorgeschlagenen Ansatzes bietet den Vorteil, durch die zeitgleiche Verwendung von zwei unterschiedlichen Energieversorgungseinheiten eine sehr robuste und sichere Versorgung des Messsensors mit elektrischer Energie bzw. mit Strom oder Spannung sicherstellen zu können.

Gemäß einer weiteren Ausführungsform des hier vorgeschlagenen Ansatzes kann die zweite Energieversorgungseinheit einen Shunt-Widerstand aufweisen, über den der Strom von der zweiten Energieversorgungseinheit in den Messsensor im Betrieb des Messsensors fließt. Eine solche Ausführungsform bietet den Vorteil, dass insbesondere bei einer Kodierung des physikalischen Parameters durch eine unterschiedliche, durch den Messsensor gesteuerte variierende Stromstärke eine technisch sehr einfache Möglichkeit besteht, den Wert des physikalischen Parameters auslesen oder übertragen zu können.

Günstig ist auch eine Ausführungsform des hier vorgeschlagenen Ansatzes, bei der der Messsensor ausgebildet ist, um einen den physikalischen Parameter repräsentierenden Wert in einem Manchster-Code zu codieren. Eine solche Ausführungsform bietet den Vorteil der technisch einfachen und mit geringem Schaltungsaufwand zu realisierenden Übertragung des von dem Messsensor erfassten Messwerts für den physikalischen Parameter.

Auch kann gemäß einer weiteren Ausführungsform des hier vorgeschlagenen Ansatzes die zweite Energieversorgungseinheit ein mit dem Steuereingang verschaltetes Schaltelement aufweisen, das ausgebildet ist, um die zweite Spannung in Abhängigkeit von einer Spannungsdifferenz zwischen einer die zweite Energieversorgungseinheit speisenden Versorgungsspannung und dem ersten Massepotenzial zu steuern. Eine solche Ausführungsform bietet den Vorteil einer besonders einfachen Implementierung bzw. Steuerung der zweiten Spannung in Beziehung zum ersten Massepotenzial, sodass die zweite Spannung derart ausgegeben werden kann, dass sie unter Berücksichtigung der ersten Spannung sowie einer Potenzialdifferenz zwischen dem ersten Massepotenzial und dem zweiten Massepotenzial bereitgestellt wird.

Vorteilhaft ist ferner eine Ausführungsform des hier vorgeschlagenen Ansatzes, bei der die erste und/oder zweite Energieversorgungseinheit zumindest einen Spannungsregler aufweist, insbesondere der als Low-Drop-out-Längsregler realisiert ist. Eine solche Ausführungsform bietet den Vorteil einer technisch sehr einfachen Realisierung für die Bestimmung bzw. Bereitstellung der ersten und/oder zweiten Spannung entsprechend den gewünschten Anforderungen.

Auch kann gemäß einer speziellen Ausführungsform der Messsensor als Drehzahlsensor ausgebildet sein, insbesondere um eine Drehzahl einer Komponente eines Fahrzeugs und/oder eines Rads eines Fahrzeugs zu erfassen. Eine solche Ausführungsform des hier vorgeschlagenen Ansatzes bietet den Vorteil, insbesondere in einer Umgebung mit hohen Sicherheitsanforderungen eine zuverlässige und robuste Messung des physikalischen Parameters durch den Messsensor gewährleisten zu können.

Auch wird gemäß einer Ausführungsform des hier vorgeschlagenen Ansatzes ein Verfahren zum Betreiben eines Messsystems gemäß einer Variante des hier vorgestellten Ansatzes vorgeschlagen, wobei das Verfahren die folgenden Schritte umfasst:
- Versorgen des Messsensors mit elektrischer Energie aus der ersten und/oder zweiten Energieversorgungseinheit; und
- Ausgeben eines Messignals durch den Messsensor, das den physikalischen Parameter repräsentiert.

Auch durch eine solche Ausführungsform in Form eines Verfahrens lassen sich die vorstehend genannten Vorteile technisch einfach realisieren, sodass der physikalische Parameter mit einer hohen Sicherheit und Robustheit auch in verschiedenen Umweltszenarien verwendet werden kann.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Ausführungsbeispiele des hier vorgestellten Ansatzes sind in den Zeichnungen dargestellt und in der nachfolgenden Beschreibung näher erläutert. Es zeigt:
- Fig. 1: ein Blockschaltbild eines Ausführungsbeispiels des hier vorgestellten Messsystems in der Verschaltung für den Normalbetrieb; und
- Fig. 2: ein Ablaufdiagramm eines Ausführungsbeispiels des hier vorgestellten Ansatzes als Verfahren zum Betreiben einer Variante eines hier beschriebenen Messsystems.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

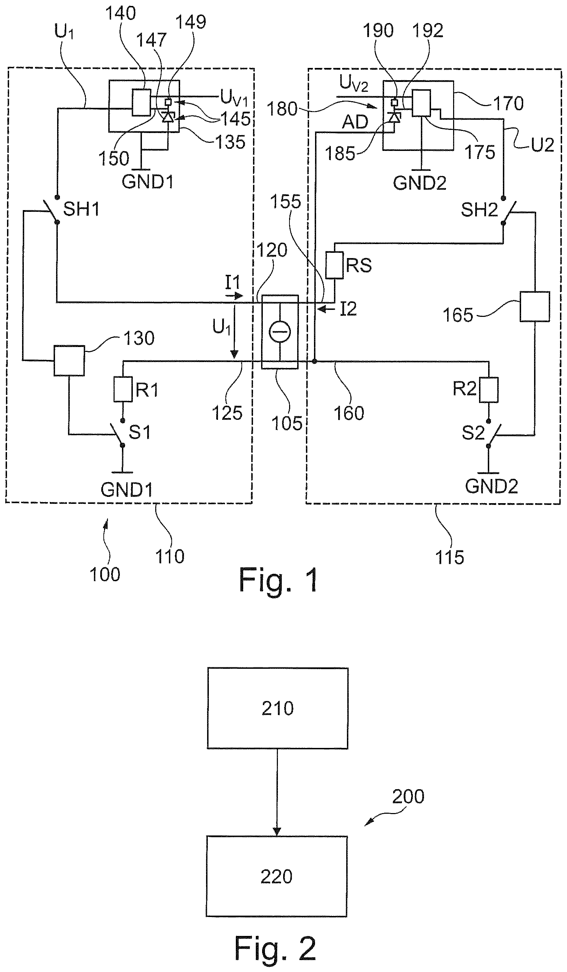

Fig. 1 zeigt ein Blockschaltbild eines Ausführungsbeispiels des hier vorgestellten Messsystems 100 in der Verschaltung für den Normalbetrieb. Das Messsystem 100 umfasst hierbei einen Messsensor 105, der zur robusten und möglichst wenig störungsanfälligen Versorgung mit elektrischer Energie aus einer ersten Energieversorgungseinheit 110 und/oder mit elektrischer Energie aus einer zweiten Energieversorgungseinheit 115 gespeist wird. Der Messsensor 105 kann beispielsweise als Sensor für eine physikalische Größe wie eine Drehzahl eines Rades eines Fahrzeugs ausgestaltet sein. Denkbar ist jedoch auch, dass der Messsensor 105 als Sensor für eine Temperatur, eine Beschleunigung, einen Druck oder dergleichen ausgestaltet ist. Um nun einen Messwert über die von dem Messsensor 105 erfasste physikalische Größe ausgeben bzw. übertragen zu können, kann vorteilhafter Weise dieser Messwert in der Form eines Manchester-Codes codiert werden und somit von einer entsprechenden Auswertungseinrichtung in oder an der ersten Energieversorgungseinheit 110 und/oder der zweiten Energieversorgungseinheit 115 ausgelesen werden. Hierzu sollte jedoch sichergestellt werden, dass die Versorgung des Messsensors 105 mit einer möglichst gleich bleibenden Spannung bzw. einem möglichst gleich bleibenden Strom versorgt wird, auch wenn in einem Fehlerfall eine Umschaltung der Versorgung des Messsensors 105 mit elektrischer Energie aus einer anderen Energieversorgungseinheit erforderlich wird. Beispielsweise ist eine solche Versorgung mit einer möglichst gleich bleibenden Spannung bei einem solchen Wechsel der Versorgungsquelle dann besonders hilfreich, wenn eine solche Kodierung des Messwerts durch den Messsensor 105 möglichst fehlerfrei ausgelesen werden soll.

Um eine solche möglichst gleichmäßige Versorgung des Messsensor 105 mit elektrischem Strom bzw. einer elektrischen Spannung sicherzustellen, kann der Messsensor 105 über einen ersten Anschluss 120 der ersten Energieversorgungseinheit 110 mit einem elektrischen Strom gespeist werden, wogegen über einen zweiten Anschluss 125 der ersten Energieversorgungseinheit 110 ein elektrischer Strom von dem Messsensor 105 abgeführt werden kann. Hierbei ist anzumerken, dass dieser Strom über den zweiten Anschluss 125 beispielsweise über einen ersten Widerstand R1 und einen ersten Schalter S1 zu dem ersten Massepotenzial GND1 abgeführt wird. Dieser erste Schalter S1 kann von einer ersten Steuereinheit 130 angesteuert werden, das heißt beispielsweise durch die Ansteuerung in einen geöffneten oder einen geschlossenen Zustand gebracht werden. Zugleich kann der ersten Anschluss 120 ausgegebene Strom I1 über einen ersten Hilfsschalter SH1, der beispielsweise wiederum von der ersten Steuereinheit 130 angesteuert werden kann, von einem ersten Spannungsregler 135 bereitgestellt werden, der beispielsweise als LDO-Regler (LDO = low drop-out) ausgestaltet ist. Hierzu wird beispielsweise der erste Spannungsregler 135 mit einer ersten Versorgungsspannung UV1 beaufschlagt und über eine erste Reglereinheit 140 derart angesteuert, dass er die erste Spannung U1 bereitstellt. Hierzu kann die Reglereinheit 140 ferner mit einem ersten Schaltelement 145 gekoppelt sein, welches zwischen die erste Versorgungsspannung UV1 und das erste Massepotenzial GND1 geschaltet ist. Beispielsweise kann das erste Schaltelement 145 eine Serienschaltung umfassend eine Z-Diode 147 sowie einen Widerstand 149 aufweisen, wobei das Potential zwischen der Z-Diode 147 und dem Widerstand 149 als Steuersignal 150 der Reglereinheit 140 verwendet wird. Durch die Wahl der Durchbruchsspannung der Z-Diode 147 kann somit beispielsweise in der Reglereinheit 140 die erste Spannung U1 angesteuert oder festegelegt werden.

Ein sehr ähnlicher Aufbau kann nun auch für die zweite Energieversorgungseinheit 115 gewählt werden, um den Messsensor 105 auch hier möglichst gleichmäßig mit elektrischem Strom bzw. einer elektrischen Spannung versorgen zu können. Die zweite Energieversorgungseinheit 115 weist hierzu einen dritten Anschluss 155 auf, über welchen der Messsensor 105 mit einem zweiten elektrischen Strom I2 gespeist werden kann. Über einen vierten Anschluss 160 der zweiten Energieversorgungseinheit 115 kann ein Strom von dem Messsensor 105 abgeführt werden. Hierbei ist anzumerken, dass dieser Strom über den vierten Anschluss 160 beispielsweise über einen zweiten Widerstand R2 und einen zweiten Schalter S2 zu dem zweiten Massepotenzial GND2 abgeführt wird. Diese zweite Schalter S2 kann von einer zweiten Steuereinheit 165 angesteuert werden, das heißt beispielsweise durch die Ansteuerung in einen geöffneten oder einen geschlossenen Zustand gebracht werden. Zugleich kann der am dritten Anschluss 155 ausgegebene Strom I2 über einen zweiten Hilfsschalter SH2, der beispielsweise wiederum mittels der zweiten Steuereinheit 165 angesteuert werden kann, von einem zweiten Spannungsregler 170 bereitgestellt werden, der beispielsweise ebenfalls als LDO-Regler ausgestaltet ist. Hierzu wird beispielsweise der zweite Spannungsregler 170 mit einer zweiten Versorgungsspannung UV2 beaufschlagt und über eine zweite Reglereinheit 175 derart angesteuert, dass er die zweite Spannung U2 bereitstellt. Hierzu kann die zweite Reglereinheit 175 ferner mit einem zweiten Schaltelement 180 gekoppelt sein, welches zwischen die zweite Versorgungsspannung UV2 über einen Steuereingang AD und nun den vierten Anschluss 160 geschaltet ist, der nun (beispielsweise über den Messsensor 105) mit dem ersten Massepotenzial GND1 gekoppelt ist. Genau genommen verläuft diese Kopplung über das erste Massepotenzial GND1, den Spannungsabfall +U_S1über den ersten Schalter S1 und den Spannungsabfall U_R1über den ersten Widerstand R1, sodass es sich hier um eine indirekte Kopplung handelt. Beispielsweise kann das Schaltelement 180 eine Serienschaltung umfassend eine zweite Z-Diode 185 sowie einen weiteren Widerstand 190 aufweisen, wobei ein Potential zwischen der zweiten Z-Diode 180 und dem weiteren Widerstand 190 als Steuersignal 192 der zweiten Reglereinheit 175 verwendet wird. Durch die Durchbruchspannung der zweiten Z-Diode 180 kann somit beispielsweise in der zweiten Reglereinheit 175 die Ausgabe der zweiten Spannung U2 angesteuert oder festegelegt werden.

Bei einer solchen Versorgungsschaltung des Messsensors 105 ist dann der erste Anschluss 120 der ersten Energieversorgungseinheit 110 mit dem dritten Anschluss 155 der zweiten Energieversorgungseinheit 115 und der zweite Anschluss 125 der ersten Energieversorgungseinheit 110 mit dem vierten Anschluss 160 der zweiten Energieversorgungseinheit 115 verbunden.

Die Kopplung des Steuereingangs AD (AD = Adjust-Steuerpin = Steuerpin zum Einlesen eines Steuersignals) der zweiten Energieversorgungseinheit 115 mit dem ersten Massepotenzial GND1 anstatt wie bei einem gleichartigen Aufbau der zweiten Energieversorgungseinheit 115 zur ersten Energieversorgungseinheit 110 mit dem zweiten Massepotenzial, ermöglicht nun die entsprechend vorteilhafte Festlegung der zweiten Spannung U2, die Spannungssprünge bei einem Wechsel der Energieversorgung des Messsensors 105 im Fehlerfall vermeiden hilft und somit für eine robuste Funktionsweise des Messsensors 105 sicherstellt.

Gemäß einem Ausführungsbeispiel des hier vorgestellten Ansatzes wird nun der Steuereingang AD der zweiten Energieversorgungseinheit 115, genauer gesagt, der zweiten Reglereinheit 175 mit dem ersten Massepotenzial GND1 verbunden, was hier über einer elektrische Verbindungsleitung des Steuereingangs AD zum vierten Anschluss 160 der zweiten Energieversorgungseinheit 115 bewirkt wird, der selbst wieder über den Messsensor 105 und den ersten Widerstand R1 sowie den ersten Schalter S1 mit dem ersten Massepotenzial gekoppelt ist. Hierdurch wird erreicht, dass bei der Regelung der zweiten Spannung U2 aus der zweiten Versorgungsspannung UV2 nicht das zweite Massepotenzial GND2 als Bezugsgröße verwendet wird, sondern das erste Massepotenzial GND1. Es kann auf diese Weise eine Einregelung der zweiten Spannung U2 erreicht werden, die zwischen dem dritten Anschluss 155 und dem vierten Anschluss 160 an den Messsensor 105 ausgegeben wird, bei der die von der ersten Energieversorgungseinheit 110 an den Messsensor 105 ausgegebene Spannung U1 sowie eine Potenzialdifferenz zwischen dem ersten und zweiten Massepotenzial berücksichtigt und ausgeglichen wird. Auf diese Weise kann auch sichergestellt werden, dass bei der in der Fig. 1 dargestellten Beschaltung kein Fehlerstrom von der ersten Energieversorgungseinheit 110 in die zweite Energieversorgungseinheit 115 aufgrund von Spannungsdifferenzen der Spannungen zwischen dem ersten Anschluss 120 und dem zweiten Anschlus 135 sowie zwischen dem dritten Anschluss 155 und dem vierten Anschluss 160 fließt. Weiterhin hilft es einen geforderten Versorgungsbereich des Sensors einzuhalten und Überspannungversorgung zu verhindern. Das kann zu vorteilhaften Verfügbarkeitseinschätzungen führen. Hierzu wäre anzumerken, dass der Sensor erweiterten Temperaturbereich zu erfüllen hat, wobei ein Sensorhersteller dies zusichert, wenn die maximale Versorgungsspannung reduziert wird (d. h. die Eigenerwärmung beschränkt wird).

Ferner ist auch ein Shunt-Widerstand RS zwischen dem zweiten Hilfsschalter SH2 und dem dritten Anschlus 155 vorgesehen, der beispielsweise zur Messung des Stromflusses I2 über den dritten Anschluss 155 in den Messsensor 105 fließt. Insbesondere wenn der Messsensor 105 einen Messwert des zu messenden physikalischen Parameters durch eine Variation des Stromflusses durch den Messsensor 105 ausgibt, kann die Verwendung eines solchen Shunt-Widerstands zu einer solchen Messung oder Auswertung des von dem Messsensor 105 derart codierten Wertes sehr vorteilhaft sein. Denkbar ist jedoch ebenfalls, dass der Stromfluss durch den Messsensor 105 bzw. der durch den Messsensor 105 variierte Stromfluss durch einen Spannungsabfall an dem ersten Widerstand R1 und/oder dem zweiten Widerstand R2 erfasst werden kann.

Um nun eine robuste und zuverlässig arbeitende Messung durch den Messsensor 105 zu gewährleisten, können die erste Steuereinheit 130 und zweite Steuereinheit 165 ausgebildet sein, um den ersten Schalter S1, den ersten Hilfsschalter SH1, den zweiten Schalter S2 und den zweiten Hilfsschalter SH2 derart zu schalten, dass beispielsweise in einem normalen Betriebsmodus, d. h. im Normalbetrieb, von der zweiten Energieversorungseinheit 115 eine Energie bzw. ein Strom I2 über den dritten Anschluss 155 dem Messsensor 105 bereitgestellt werden und der vom Messsensor 105 abfließende Strom über den zweiten Anschluss 125 der ersten Energieversorgungseinheit 110 über den ersten Widerstand R1 und den ersten Schalter S1 geleitet werden.

Sollte jedoch nun in der ersten Energieversorgungseinheit 110 oder in der zweiten Energieversorgungseinheit 115 ein Fehler auftreten, der beispielsweise über eine in der Fig. 1 nicht dargestellte Fehlererkennungseinheit an die erste Steuereinheit 130 und/oder die zweite Steuereinheit 165 übermittelt wird, können die betreffenden Steuereinheiten 130 bzw. 165 die durch sie gesteuerten Schalter S1, SH1, S2 und SH2 derart schalten, dass ein Stromfluss über die fehlerhafte Energieversorgungseinheit unterbleibt.

Speziell kann dann beispielsweise bei einem aufgetretenen Fehler in der ersten Energieversorgungseinheit 110 durch die erste Steuereinheit die betreffenden Schalter derart angesteuert geschaltet werden, dass der erste Schalter S1 und/oder der erste Hilfsschalter SH1 geöffnet werden, sodass über den ersten Anschluss 120 und/oder den zweiten Anschluss 125 kein Strom mehr fließen kann. Alternativ oder zusätzlich kann die zweite Steuereinheit 165 derart angesteuert werden, dass zweite Schalter S2 und der zweite Hilfsschalter SH2 geschlossen werden, sodass über den dritten Anschluss 155 und den vierten Anschluss 160 ein Strom fließen kann, sodass die Versorgung des Messsensors 105 mit elektrischer Energie nur durch die zweite Energieversorgungseinheit 115 ermöglicht wird.

Andersherum kann dann beispielsweise bei einem aufgetretenen Fehler in der zweiten Energieversorgungseinheit 115 die erste Steuereinheit derart geschaltet werden, dass der erste Schalter S1 und der erste Hilfsschalter SH1 geschlossen werden, sodass über den ersten Anschluss 120 und den zweiten Anschluss 125 Strom fließen kann. Alternativ oder zusätzlich kann die zweite Steuereinheit 165 derart angesteuert werden, dass zweite Schalter S2 und/oder der zweite Hilfsschalter SH2 geöffnet werden, sodass über den dritten Anschluss 155 und den vierten Anschluss 160 kein Strom fließen kann, sodass die Versorgung des Messsensors 105 mit elektrischer Energie nur durch die erste Energieversorgungseinheit 115 ermöglicht wird.

**Fig. 2** zeigt ein Ablaufdiagramm eines Ausführungsbeispiels des hier vorgestellten Ansatzes als Verfahren 200 zum Betreiben einer Variante eines hier beschriebenen Messsystems. Das Verfahren 200 umfasst einen Schritt 210 des Versorgens des Messsensors mit elektrischer Energie aus der ersten und/oder zweiten Energieversorgungseinheit und einen Schritt 220 des Ausgebens eines Messignals durch den Messsensor, das den physikalischen Parameter repräsentiert.

Zusammenfassend wird vorliegend eine Möglichkeit für ein Prinzip und ein Schaltungsvorschlag zur Generierung eines variablen Bezugspotenzials einer Spannungsquelle für die Diagonal-Versorgung eines Sensors von zwei Steuergeräten vorgestellt.

Als Weiterentwicklung lässt sich das Grundprinzip der Diagonalversorgung- und Auswertung eines Sensors (Ausführungsbeispiel aWSS) durch zwei elektronische Steuergeräte bzw. Energieversorgungseinheiten erläutern, dem die folgende Problemstellung zugrunde liegt, dass die primäre sowie die redundante ECU (die hier als erste und zweite Energieversorgungseinheit 110 bzw. 115 bezeichnet werden), in der Regel aus unterschiedlichen Spannungsversorgungen gespeist und somit einen durch das verwendete Kabel unterschiedlichen Massebezug haben. Auch bei einer Versorgung aus einer gemeinsamen Spannungsversorgung sollte ein kontinuierlicher sich verändernder Masseversatz zwischen primärer 110 und redundanter 115 ECU bzw. Energieversorgungseinheit angenommen werden. Dieser Masseversatz oder die Störungen über das unterschiedliche Massepotential erschweren die Auswertung und die Sicherstellung des erlaubten Spannungsbereichs des von dem Messsensor 105 ausgegebenen Sensorsignals. Es kommt zu Spannungseinbrüchen der Spannungsversorgung des Sensors bzw. Messsensors 105 welche wiederum dazu führen können, dass das Sensorsignal beeinträchtigt wird. Daraus ergibt sich dann ein fehlerhaftes Auswerteprotokoll des Sensors 105. Der hier vorgestellte Ansatz umfasst einen beispielhaften Schaltungsvorschlag der gezielt auf die Probleme bezüglich Masseversätze bei der Diagonalversorgung- und Auswertung eines aktiven Wheel Speed Sensors als Messsensor 105 eingeht.

Die Darstellung aus der Fig. 1 zeigt die elektrische Beschaltung des primären 110 sowie des redundanten 115 Steuergerätes bzw. der jeweiligen Energieversorgungseinheit 110 bzw. 115 hinsichtlich der Diagonalversorgung- und Auswertung eines aktiven Wheel Speed Sensors (aWSS) als Messsenors 105 und stellt den Normalbetrieb die beiden ECUs bzw. Energieversorgungseinheiten 110 und 115 dar. Hierbei liegt ein Stromverlauf vor, beginnend der Redundanz-ECU bzw. zweiter Energieversorgungseinheit 115 mit dem Versorgungsspannungspegel UV1 über den LDO bzw. die zweite Reglereinheit 170 über den rückstromgesicherten Versorgungsschalter als zweiten Hilfsschalter SH2 mit dem Shunt RS auf der Highside (die beispielsweise auch einen Stromspiegel aufweist) über den hier als aktiven Drehzahlsensor ausgestalteten Messsensor 105 zum Shunt als erstem Widerstand R1 auf Lowside dar. Der Grundgedanke des hier vorgestellten Ansatzes beschreibt hier das Prinzip und ein konkretes Ausführungsbeispiel inkl. Schaltungsvorschlag, dass das Bezugspotenzial der Referenzspannung für die Spannungsregelung der Quelle, die hier als erster Reglereinheit 135 vorliegt, sich auf das Bezugspotenzial der primären ECU bezieht (hier der Strang zwischen dem zweiten Anschluss 125 und dem ersten Massepotenzial GND1). Im Normalfall, der die Verschaltung gemäß der Darstellung aus der Fig. 1 zu entnehmen ist, ist das Bezugspotenzial die eigene Steuergerätemasse wie in der Fig. 1 zu erkennen ist. Dieser Massebezug zum primären Steuergerät 110 zur Regelung des LDOs als Reglereinheit 135 des redundanten Steuergerätes bzw. der zweiten Energieversorgungseinheit 115 erhöht die Robustheit des Sensorprotokolls gegenüber Masseversätzen. Hierbei wird die Anode der als Schaltelement verwendeten Diode 185 bzw. 147 nicht mehr mit der internen Masse, sondern mit dem Bezug zum Signal anliegend am vierten Anschluss 160 gewählt. Dieses Bezugspotenzial entspricht im Wesentlichen dem gleichen Potenzial der primären ECU bzw. der ersten Energieversorgungseinheit 110. Wichtig bei der Auswahl des Massebezug GND2 ist, dass ein sicherer Betrieb auch bei Ausfall eines Steuergerätes 130, 165 gewährleistet wird. Der Massebezug der redundanten ECU 115 zur primäre ECU 110 ändert nichts am Spannungsverlauf. Bei einem Ausfall der primären ECU bzw. der erstgen Energieversorgungseinheit 110 wird ebenfalls ein sicherer Betrieb gewährleistet. Die Module bzw. Energieversorgungseinheiten 110 bzw. 115 wurden im Kurzen vorstehend beschrieben. In einer weiteren Ausbaustufe kann auch eine Implementierung eines Filtergliedes zwischen dem vierten Anschluss 160 und der Diode als zweitem Schaltelement 185 vogesehen sein. Hierbei kann die Regeldynamik des LDOs eingeschränkt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

### BEZUGSZEICHENLISTE

- 100: Messsystem
- 105: Messsensor 105
- 110: erste Energieversorgungseinheit
- 115: zweite Energieversorgungseinheit
- 120: erster Anschluss
- 125: zweiter Anschluss
- 130: erste Steuereinheit
- 135: Reglereinheit
- 140: Spannungsregler
- 145: Schaltelement
- 147: erste Z-Diode
- 149: Widerstand
- 150: Abgriffspunkt
- UV1: erste Versorgungspannuung
- U1: erste Spannung
- S1: erster Schalter
- R1: erster Widerstand
- SH1: erster Hilfsschalter
- I1: erster Strom
- GND1: erstes Massepotenzial

- 155: dritter Anschluss
- 160: vierter Anschluss
- 165: zweites Steuergerät
- 170: zweite Reglereinheit
- 175: zweiter Spannungsregler
- 180: zweites Schaltelement
- AD: Steuereingang
- 185: zweite Z-Diode
- 190: Widerstand
- U2: zweite Spannung
- UZV: zweite Versorgungsspannung
- I2: zweiter Stromfluss
- SH2: zweiter Hilfsschalter
- R2: zweiter Widerstand
- RS: Shunt-Widerstand
- GND2: zweites Massepotenzial

- 200: Verfahren zum Betreiben eines Messsystems gemäß einer hier vorgestellten Variante
- 210: Schritt des Versorgens
- 220: Schritt des Ausgebens

## Patentansprüche

1. Messsystem (100) zur Erfassung eines physikalischen Parameters, wobei das Messsystem (100) die folgenden Merkmale aufweist:
- einen Messsensor (105) zur Erfassung des physikalischen Parameters;
- eine erste Energieversorgungseinheit (110) zur Ausgabe eines Stroms oder von elektrischer Energie an den Messsensor (105), wobei die erste Energieversorgungseinheit(110, 115) ausgebildet ist, um die elektrische Energie mit einer ersten Spannung (U1) in Bezug auf ein erstes Massepotenzial (GND1) an den Messsensor (105) auszugeben; und
- eine zweite Energieversorgungseinheit (115) zur Ausgabe eines Stroms (I2) oder von elektrischer Energie an den Messsensor (105), wobei die zweite Energieversorgungseinheit (115) ausgebildet ist, um die elektrische Energie mit einer zweiten Spannung (U2) in Bezug auf ein zweites Massepotenzial (GND2) an den Messsensor (105) auszugeben, wobei das erste Massepotenzial (GND1) von dem zweiten Massepotenzial (GND2) abweicht,
**dadurch gekennzeichnet, dass**
die erste Energieversorgungseinheit (110) und die zweite Energieversorgungseinheit (115) auf unterschiedlichen Massepotenzialen (GND1, GND2) gestützt sind, wobei die zweite Energieversorgungseinheit (115) einen Steuereingang (AD) zur Einstellung der zweiten Spannung (U2) aufweist, wobei der Steuereingang (AD) mit dem ersten Massepotenzial (GND1) gekoppelt ist, um die zweite Energieversorgungseinheit (115) derart anzusteuern, dass die von der zweiten Energieversorgungseinheit (115) an den Messsensor (105) ausgegebene Spannung der ersten Spannung (U1) in Bezug auf das erste Massepotenzial (GND1) entspricht.

2. Messsystem (100) gemäß Anspruch 1, **dadurch gekennzeichnet, dass** die erste Energieversorgungseinheit (110) zumindest einen durch eine erste Steuereinheit (130) steuerbaren ersten Schalter (S1) aufweist, um einen Stromfluss von dem Messsensor (105) durch die erste Energieversorgungseinheit (110) zu dem ersten Massepotenzial (GND1) zu unterbrechen und/oder dass die zweite Energieversorgungseinheit (115) zumindest einen durch eine zweite Steuereinheit (165) steuerbaren zweiten Schalter (S2) aufweist, um einen Stromfluss von dem Messsensor (105) durch die zweite Energieversorgungseinheit (115) zu dem zweiten Massepotenzial (GND2) zu unterbrechen.

3. Messsystem (100) gemäß Anspruch 2, **dadurch gekennzeichnet, dass** die erste Steuereinheit (130) ausgebildet ist, um den ersten Schalter (S1) zu öffnen, wenn eine Fehlfunktion der ersten Energieversorgungseinheit (110) erkannt wurde und/oder wobei die zweite Steuereinheit (165) ausgebildet ist, um den zweiten Schalter (S2) zu öffnen, wenn eine Fehlfunktion der zweiten Energieversorgungseinheit (115) erkannt wurde.

4. Messsystem (100) gemäß Anspruch 2 oder 3, **dadurch gekennzeichnet, dass** die erste Steuereinheit (130) ausgebildet ist, um den ersten Schalter (S1) zu schließen oder geschlossen zu halten, wenn eine Fehlfunktion in der zweiten Energieversorgungseinheit (115) erkannt wurde und/oder wobei die zweite Steuereinheit (165) ausgebildet ist, um den zweiten Schalter (S2) zu schließen/geschlossen zu halten, wenn in der ersten Energieversorgungseinheit (110) eine Fehlfunktion erkannt wurde.

5. Messsystem (100) gemäß einem der vorangegangenen Ansprüche, **dadurch gekennzeichnet, dass** der Messsensor (105) derart mit der ersten (110) und zweiten Energieversorgungseinheit (115) in einer Versorgungsschaltung verschaltet ist, dass ihm ein Strom (I2) von der zweiten Energieversorgungseinheit (115) zugeführt wird und ein Strom von ihm zu der ersten Energieversorgungseinheit (110) abgeführt wird, wobei der Messsensor (105) in einem Normalbetrieb in der Versorgungsschaltung geschaltet ist.

6. Messsystem (100) gemäß einem der vorangegangenen Ansprüche, **dadurch gekennzeichnet, dass** die zweite Energieversorgungseinheit (115) einen Shunt-Widerstand (RS) aufweist, über den der Strom (I2) von der zweiten Energieversorgungseinheit (115) im Betrieb des Messsensors (105) in den Messsensor (105) fließt.

7. Messsystem (100) gemäß einem der vorangegangenen Ansprüche, **dadurch gekennzeichnet, dass** der Messsensor (105) ausgebildet ist, um einen den physikalischen Parameter repräsentierenden Wert in einem Manchester-Code zu codieren.

8. Messsystem (100) gemäß einem der vorangegangenen Ansprüche, **dadurch gekennzeichnet, dass** die zweite Energieversorgungseinheit (115) ein mit dem Steuereingang (AD) verschaltetes Schaltelement (180, 185) aufweist, das ausgebildet ist, um die zweite Spannung (U2) in Abhängigkeit von einer Spannungsdifferenz zwischen einer die zweite Energieversorgungseinheit (115) speisenden Versorgungsspannung (UV2) und dem ersten Massepotenzial (GND1) zu steuern.

9. Messsystem gemäß einem der vorangegangenen Ansprüche, **dadurch gekennzeichnet, dass** die erste (110) und/oder zweite Energieversorgungseinheit (115) zumindest einen Spannungsregler (135, 140, 170, 175) aufweist, der als Low-Drop-out-Längsregler realisiert ist.

10. Messsystem (100) gemäß einem der vorangegangenen Ansprüche, **dadurch gekennzeichnet, dass** der Messsensor (105) als Drehzahlsensor ausgebildet ist, um eine Drehzahl einer Komponente eines Fahrzeugs und/oder eines Rads eines Fahrzeugs zu erfassen.

11. Verfahren (200) zum Betreiben eines Messsystems (100) gemäß einem der vorangegangenen Ansprüche 1 bis 10, wobei das Verfahren (200) die folgenden Schritte umfasst:
- Versorgen (210) des Messsensors (105) mit elektrischer Energie aus der ersten und/oder zweiten Energieversorgungseinheit(110, 115) ; und
- Ausgeben (220) eines Messsignals durch den Messsensor (105), das den physikalischen Parameter repräsentiert.

12. Computerprogramm, umfassend Befehle, die bewirken, dass das Messsystem gemäß einem der Ansprüche 1 bis 10 die Schritte des Verfahrens (200) nach Anspruch 11 ausführt.

13. Maschinenlesbares Speichermedium, auf dem das Computerprogramm nach Anspruch 12 gespeichert ist.

## Claims

1. Measurement system (100) for detecting a physical parameter, wherein the measurement system (100) has the following features:
- a measurement sensor (105) for detecting the physical parameter,
- a first power supply unit (110) for outputting a current or electric power to the measurement sensor (105), wherein the first power supply unit (110, 115) is designed to output electric power with a first voltage (U1) in relation to a first ground potential (GND1) to the measurement sensor (105), and
- a second power supply unit (115) for outputting a current (12) or electric power to the measurement sensor (105), wherein the second power supply unit (115) is designed to output electric power with a second voltage (U2) in relation to a second ground potential (GND2) to the measurement sensor (105), wherein the first ground potential (GND1) differs from the second ground potential (GND2),
**characterised in that**
the first power supply unit (110) and the second power supply unit (115) are based on different ground potentials (GND1, GND2), wherein the second power supply unit (115) has a control input (AD) for adjusting the second voltage (U2), wherein the control input (AD) is coupled to the first ground potential (GND1), in order to control the second power supply unit (115) such that the voltage output to the measurement sensor (105) by the second power supply unit (115) corresponds to the first voltage (U1) in relation to the first ground potential (GND1).

2. Measurement system (100) according to claim1, **characterised in that** the first power supply unit (110) has at least a first switch (S1) that can be controlled by a first controller (130) for interrupting a flow of power from the measurement sensor (105) through the first power supply unit (110) to the first ground potential (GND1) and/or **in that** the second power supply unit (115) has at least a second switch (S2) that can be controlled by a second controller (165) for interrupting a flow of power from the measurement sensor (105) through the second power supply unit (115) to the second ground potential (GND2).

3. Measurement system (100) according to claim 2, **characterised in that** the first controller (130) is designed to open the first switch (S1) when a malfunction of the first power supply unit (110) is detected and/or wherein the second controller (165) is designed to open the second switch (S2) when a malfunction of the second power supply unit (115) is detected.

4. Measurement system (100) according to claim 2 or 3, **characterised in that** the first controller (130) is designed to close the first switch (S1) or keep it closed when a malfunction is detected in the second power supply unit (115) and/or wherein the second controller (165) is designed to close the second switch (S2) or keep it closed when a malfunction is detected in the first power supply unit (110).

5. Measurement system (100) according to any one of the preceding claims, **characterised in that** the measurement sensor (105) is connected in a supply circuit with the first (110) and second power supply unit (115) such that it is supplied with a current (12) by the second power supply unit (115) and a current is discharged from it to the first power supply unit (110), wherein the measurement sensor (105) is connected in the supply circuit in normal operation.

6. Measurement system (100) according to any one of the preceding claims, **characterised in that** the second power supply unit (115) has a shunt resistor (RS), via which the current (12) flows from the second power supply unit (115) into the measurement sensor (105) during operation of the measurement sensor (105)

7. Measurement system (100) according to any one of the preceding claims, **characterised in that** the measurement sensor (105) is designed to code a value representing the physical parameter in a Manchester code.

8. Measurement system (100) according to any one of the preceding claims, **characterised in that** the second power supply unit (115) has a switch element (180, 185) connected with the control input (AD), which is designed to control the second voltage (U2) as a function of a voltage difference between a supply voltage (UV2) supplying the second power supply unit (115) and the first ground potential (GND1).

9. Measurement system according to any one of the preceding claims, **characterised in that** the first (110) and/or second power supply unit (115) has at least a voltage regulator (135, 140, 170, 175), which is implemented as a linear low-dropout regulator.

10. Measurement system (100) according to any one of the preceding claims, **characterised in that** the measurement sensor (105) is designed as a speed sensor for detecting a rotational speed of a vehicle component and/or a vehicle wheel.

11. Method (200) for operating a measurement system (100) according to any one of the preceding claims 1 to 10, wherein the method (200) comprises the following steps:
- Supplying (210) the measurement sensor (105) with electric power from the first and/or second power supply unit(110, 115), and
- Outputting (220) a measurement signal by means of the measurement sensor (105), which represents the physical parameter.

12. Computer program comprising commands, the effect of which is that the measurement system according to any one of claims 1 to 10 performs the method (200) steps according to claim 11.

13. Machine-readable storage medium, on which the computer program according to claim 12 is stored.

## Revendications

1. Système de mesure (100) pour détecter un paramètre physique, dans lequel le système de mesure (100) présente les caractéristiques suivantes :
- un capteur de mesure (105) pour détecter le paramètre physique ;
- une première unité d'alimentation en énergie (110) pour délivrer en sortie un courant ou de l'énergie électrique au capteur de mesure (105), dans lequel la première unité d'alimentation en énergie (110, 115) est conçue pour délivrer l'énergie électrique au capteur de mesure (105) avec une première tension (U1) par rapport à un premier potentiel de masse (GND1) ; et
- une deuxième unité d'alimentation en énergie (115) pour délivrer en sortie un courant (I2) ou de l'énergie électrique au capteur de mesure (105), dans lequel la deuxième unité d'alimentation en énergie (115) est conçue pour délivrer l'énergie électrique au capteur de mesure (105) avec une deuxième tension (U2) par rapport à un deuxième potentiel de masse (GND2), dans lequel le premier potentiel de masse (GND1) est différent du deuxième potentiel de masse (GND2),
**caractérisé en ce que**
la première unité d'alimentation en énergie (110) et la deuxième unité d'alimentation en énergie (115) sont soutenues sur des potentiels de masse (GND1, GND2) différents, dans lequel la deuxième unité d'alimentation en énergie (115) présente une entrée de commande (AD) pour le réglage de la deuxième tension (U2), dans lequel l'entrée de commande (AD) est couplée au premier potentiel de masse (GND1) pour commander la deuxième unité d'alimentation en énergie (115) de telle sorte que la tension délivrée par la deuxième unité d'alimentation en énergie (115) au niveau du capteur de mesure (105) correspond à la première tension (U1) par rapport au premier potentiel de masse (GND1).

2. Système de mesure (100) selon la revendication 1, **caractérisé en ce que** la première unité d'alimentation en énergie (110) présente au moins un premier commutateur (S1) pouvant être commandé par un premier dispositif de commande (130), pour interrompre un flux de courant du capteur de mesure (105) à travers la première unité d'alimentation en énergie (110) vers le premier potentiel de masse (GND1) et/ou **en ce que** la deuxième unité d'alimentation en énergie (115) présente au moins un deuxième commutateur (S2) pouvant être commandé par un premier dispositif de commande (165), pour interrompre un flux de courant du capteur de mesure (105) à travers la deuxième unité d'alimentation en énergie (115) vers le deuxième potentiel de masse (GND2).

3. Système de mesure (100) selon la revendication 2, **caractérisé en ce que** un premier dispositif de commande (130) est conçu pour ouvrir le premier commutateur (S1) lorsqu'un dysfonctionnement de la première unité d'alimentation en énergie (110) a été détecté et/ou dans lequel un premier dispositif de commande (165) est conçu pour ouvrir le deuxième commutateur (S2) lorsqu'un dysfonctionnement de la deuxième unité d'alimentation en énergie (115) a été détecté.

4. Système de mesure (100) selon la revendication 2 ou 3, **caractérisé en ce que** un premier dispositif de commande (130) est adapté pour fermer ou maintenir fermé le premier commutateur (S1) lorsqu'un dysfonctionnement a été détecté dans la deuxième unité d'alimentation en énergie (115) et/ou dans lequel un premier dispositif de commande (165) est adapté pour fermer/maintenir fermé le deuxième commutateur (S2) lorsqu'un dysfonctionnement a été détecté dans la première unité d'alimentation en énergie (110).

5. Système de mesure (100) selon l'une quelconque des revendications précédentes, **caractérisé en ce que** le capteur de mesure (105) est connecté aux première (110) et deuxième (115) unités d'alimentation en énergie dans un circuit d'alimentation de telle sorte qu'un courant (12) lui est fourni par la deuxième unité d'alimentation en énergie (115) et qu'un courant est évacué de celui-ci vers la première unité d'alimentation en énergie (110), dans lequel le capteur de mesure (105) est connecté dans le circuit d'alimentation en fonctionnement normal.

6. Système de mesure (100) selon l'une quelconque des revendications précédentes, **caractérisé en ce que** la deuxième unité d'alimentation en énergie (115) présente une résistance de shuntage (RS) par laquelle le courant (12) de la seconde unité d'alimentation en énergie (115) circule dans le capteur de mesure (105) pendant le fonctionnement du capteur de mesure (105).

7. Système de mesure (100) selon l'une quelconque des revendications précédentes, **caractérisé en ce que** le capteur de mesure (105) est conçu pour coder une valeur représentative du paramètre physique dans un code Manchester.

8. Système de mesure (100) selon l'une quelconque des revendications précédentes, **caractérisé en ce que** la deuxième unité d'alimentation en énergie (115) présente un élément de commutation (180, 185) connecté à l'entrée de commande (AD) qui est conçu pour commander la deuxième tension (U2) en fonction d'une différence de tension entre une tension d'alimentation (UV2) alimentant la deuxième unité d'alimentation en énergie (115) et le premier potentiel de masse (GND1).

9. Système de mesure selon l'une quelconque des revendications précédentes, **caractérisé en ce que** la première (110) et/ou la deuxième unité d'alimentation en énergie (115) présentent au moins un régulateur de tension (135, 140, 170, 175) qui est réalisé sous la forme d'un régulateur longitudinal low drop-out.

10. Système de mesure (100) selon l'une quelconque des revendications précédentes, **caractérisé en ce que** le capteur de mesure (105) est conçu comme un capteur de vitesse de rotation pour détecter une vitesse de rotation d'un composant d'un véhicule et/ou d'une roue d'un véhicule.

11. Procédé (200) de fonctionnement d'un système de mesure (100) selon l'une quelconque des revendications 1 à 10 précédentes, dans lequel le procédé (200) comprend les étapes suivantes :
- alimentation (210) du capteur de mesure (105) en énergie électrique à partir de la première et/ou de la deuxième unité d'alimentation en énergie (110, 115) ; et
- émission (220) par le capteur de mesure (105) d'un signal de mesure qui représente le paramètre physique.

12. Programme informatique comprenant des ordres qui font en sorte que le système de mesure selon l'une quelconque des revendications 1 à 10 exécute les étapes du procédé (200) selon la revendication 11.

13. Support de stockage lisible par machine sur lequel le programme informatique selon la revendication 12 est stocké.
